# EUROPÄISCHE PATENTSCHRIFT

(11) **EP 0 468 989 B1**
(45) Veröffentlichungstag und Bekanntmachung des Hinweises auf die Patenterteilung: **30.06.1993**
(21) Anmeldenummer: 90905508.9
(22) Anmeldetag: 10.04.1990
(51) Int. Cl.: H03D 13/00, G11B 19/24, H02P 5/17

(54) **REGELSCHALTUNG**
CONTROL CIRCUIT
CIRCUIT DE REGULATION

(30) Priorität: 19.04.1989 DE 3912837
(43) Veröffentlichungstag der Anmeldung: 05.02.1992
(73) Patentinhaber: DEUTSCHE THOMSON-BRANDT GMBH, 78048 Villingen-Schwenningen (DE)
(72) Erfinder: BIGGE, Franz, D-7730 Villingen (DE)
(74) Vertreter: Einsel, Robert, Dipl.-Ing.
(86) Internationale Anmeldenummer: EP9000560
(87) Internationale Veröffentlichungsnummer: WO9013172

(56) Entgegenhaltungen:
- EP-A- 0 085 615
- EP-A- 0 123 946
- EP-A- 0 238 041
- FR-A- 2 370 388
- US-A- 4 167 711
- US-A- 4 745 372
- IBM TECHNICAL DISCLOSURE BULLETIN, vol. 13, No. 3, August 1970, New York (US), pages 689-690 ; N.K. ARTER u.a. : "Motor Control Circuit".
- ELECTRONICS, vol. 49, No. 7, 1 April 1976, New York (US), pages 86-90 ; L. PENNER : "Digital Television Tuner Uses MOS LSI and Nonvolatile Memory", see page 90.

## Beschreibung

Die Erfindung geht aus von einer Regelschaltung gemäß dem Oberbegriff des Anspruchs 1. Eine derartige Schaltung ist bekannt durch die EP-A2-0 238 041.

Eine solche Regelschaltung für eine Frequenzregelung wird z.B. bei einem Aufzeichnungsträger in Form einer Platte mit einer spiralförmigen Spur, z.B. einer CD- oder MOD-Platte, benötigt. Auf einer solchen Platte ist entlang der spiralförmigen Spur ein Pilotsignal konstanter Frequenz aufgezeichnet, mit dem der Aufzeichnungsträger bei der Aufnahme und bei der Wiedergabe in der Drehzahl so geregelt wird, daß die Umfangsgeschwindigkeit am Orte des Abtasters und damit die Abtastgeschwindigkeit über den ganzen Radius konstant bleiben. Die von der Platte abgetastete Frequenz wird dabei einem Prozessor zugeführt, in dem aus der Frequenzabweichung ein impulsweitenmoduliertes Signal gewonnen wird, das dann über den Umschalter und den Tiefpaß die analoge Regelspannung für die Drehzahl des Aufzeichnungsträgers liefert. Ein derartiger Prozessor liefert z.B. für die Drehzahlregelung des Motors ein PWM-Signal mit 256 Stufen über den Gesamtbereich der Frequenzabweichung, die durch die Regelschaltung ausgeregelt werden soll. Bezogen auf den Grobregelbereich, der im wesentlichen beim Einschalten und beim Einfangen der Regelschaltung wirksam ist, ist diese Stufenzahl in allgemeinen ausreichend. Für den stationären, synchronen Fein-Regelbereich, der nur einen kleinen Anteil des gesamten Grob-Regelbereiches darstellt, ist indessen die verbleibende Stufenzahl für eine einwandfreie und genaue Regelung der Drehzahl des Motors nicht ausreichend. Vielmehr ist in diesem Synchronzustand eine größere Auflösung, also eine größere Stufenzahl innerhalb des Fein-Regelbereiches erwünscht. Eine derart größere Stufenzahl innerhalb des Fein-Regelbereiches läßt sich mit einem Prozessor mit einer entsprechend erhöhten Stufenzahl von z.B. 2048 entsprechend 11 Bit über den Gesamtregelbereich erreichen. Ein derartiger Prozessor ist aber in der Praxis in vielen Fällen nicht verfügbar, so daß weiter mit einem Prozessor mit einer PWM mit 8 Bit entsprechend 256 Stufen gearbeitet werden muß.

Der Erfindung liegt die Aufgabe zugrunde, eine Regelschaltung der beschriebenen Art so weiterzubilden, daß ohne Änderung der durch den Prozessor vorgegebenen Stufenzahl der PWM der Fein-Regelbereich mit einer erhöhten Auflösung ohne Beeinträchtigung des Grob-Regelbereiches erzielt wird. Diese Aufgabe wird durch die im Anspruch 1 angegebene Erfindung gelöst. Vorteilhafte Weiterbildungen der Erfindung sind in den Unteransprüchen angegeben.

Es ist auch eine PLL-Schaltung bekannt (US-A-4 167 711), bei der zwei Paar Stromquellen voneinander verschiedener Ströme vorgesehen sind, die umgeschaltet werden können, um eine entsprechende Regelung des VCO der PLL-Schaltung zu erzielen. Auch dort ist ein Tiefpaß vorgesehen, der eine binäre Regelspannung in eine analoge Regelspannung umwandelt. Eine Umschaltung zwischen einem Fein-Regelbereich und einem Grob--Regelbereich mit gleichzeitiger Umschaltung des Modulationsgrades einer Impulsweitenmodulation zur Erzielung eines kontinuierlichen Verlaufes der erzeugten analogen Regelspannung über beide Regelbereiche ist dort jedoch nicht vorgesehen.

Es ist ferner bekannt (DE-A-20 00 907), daß eine Phasenvergleichsschaltung zur Erzeugung einer vom Phasenverhältnis zweier Wechselspannungen abhängigen Regelspannung, bei der die Wechselspannungen je einen Schalter periodisch durchlässig steuern und die Schalter je einen Umladeweg für eine gemeinsame, die Regelspannung liefernde Ladekapazität schließen.

Bei der Erfindung werden mit den beiden Umschaltern, an die unterschiedliche hohe Gleichspannungen angelegt sind, zwei Regelbereiche geschaffen, zwischen denen mit dem Wahlschalter entsprechend der jeweiligen Abweichung umgeschaltet wird. Für den Fein-Regelbereich, der nur einen Teil des Gesamtregelbereiches darstellt, wird dabei trotzdem die gesamte im Prozessor verfügbare Stufenzahl von z.B. 256 der PWM ausgenutzt. Für die Feinregelung, die im stationären, synchronen Betrieb, also während der überwiegenden Zeit vorliegt, wird also eine hohe Auflösung entsprechend der verfügbaren Stufenzahl der PWM erreicht. Der Grob-Regelbereich wird indessen nicht verringert. Die Auflösung innerhalb des Grob-Regelbereiches ist zwar entsprechend geringer. Das bedeutet aber keinen Nachteil, da einerseits der Grob-Regelbereich nur beim Einschalten und zum Einfangen wirksam ist und dann eine geringere Stufenzahl zur Beschleunigung des Einfangvorganges sogar vorteilhaft sein kann.

Die Erfindung ist grundsätzlich anwendbar zur Umwandlung eines impulsweitenmodulierten Signals in eine analoge Regelspannung. Eine derartige Anwendung kann erfolgen in CD-Spielern, MOD-Spielern, Fernsehempfängern und Videorecordern. Sie kann auch dazu dienen, ein impulsweitenmoduliertes Signal zu demodulieren, also eine sogenannte PWM (Pulsweitenmodulation) zu decodieren und das aufmodulierte Signal zurückzugewinnen.

Die Erfindung wird im folgendem anhand der Zeichnung an einem Ausführungsbeispiel für eine Frequenzregelschaltung erläutert. Darin zeigen
- Fig. 1: im Prinzip die bekannte Regelschaltung,
- Fig. 2: die erfindungsgemäß ausgebildete Regelschaltung,
- Fig. 3, 4: Diagramme zur Erläuterung der Wirkungsweise der Schaltung nach Fig. 2

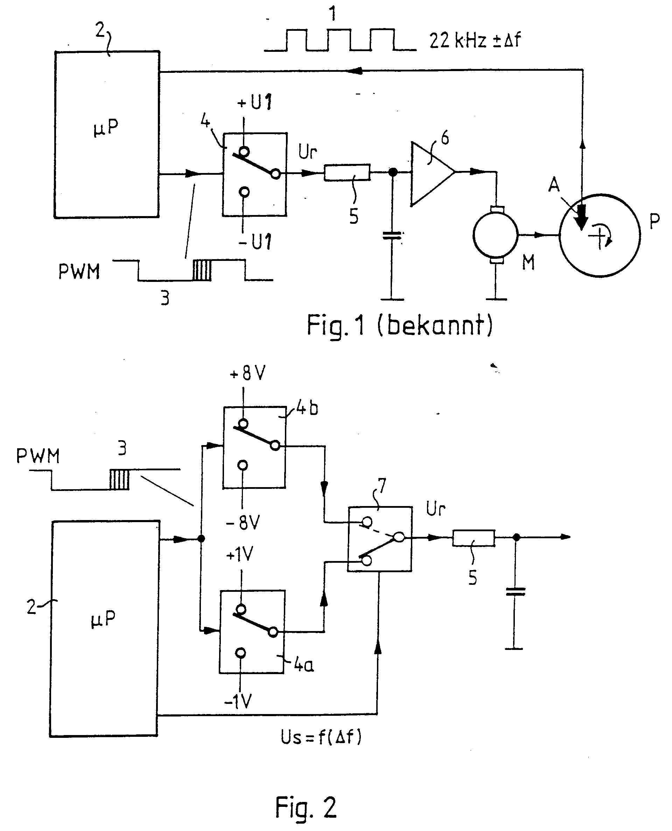

Fig. 1 zeigt den Motor M, der eine CD- oder MOD-Platte P mit einer spiralförmigen Spur antreibt. Der Abtaster A für die Platte P liefert ein bereits aufgezeichnetes Signal 1 mit der Frequenz von 22 kHz. Für eine konstante Abtastgeschwindigkeit muß die Drehzahl der Platte P derart geregelt, nämlich zum äußeren Plattenrand hin verringert werden, daß trotz der Änderung des jeweiligen Abtastradius das Signal 1 stets eine Frequenz von 22 kHz hat. Das Signal 1 wird dem Prozessor 2 zugeführt und dort in der Frequenz ausgewertet. Der Prozessor 2 liefert aufgrund der Frequenzauswertung des Signals 1 das impulsweitenmodulierte Signal 3 mit einer Frequenz von 8 kHz, das entsprechend der jeweiligen Frequenzabweichung ausgehend vom Tastverhältnis 1:1 in der Impulsweite moduliert ist. Das Signal 3 steuert den Umschalter 4, dessen Ausgang dadurch zwischen den Gleichspannungen von +U1 und -U1 umgeschaltet wird. Der an den Ausgang des Umschalters 4 angeschlossene Tiefpaß 5 liefert eine Regelspannung Ur. Die Höhe dieser Regelspannung ist in Amplitude und Polarität von der jeweiligen Frequenzabweichung des Signals 1 abhängig. Die Regelspannung Ur gelangt über den Verstärker 6 auf einen Eingang des Motors M und regelt dessen Drehzahl auf konstante Frequenz des Signals 1 und damit auf konstante Abtastgeschwindigkeit des Abtasters A.

In Fig. 2 steuert das Signal 3 gleichzeitig zwei Umschalter 4a und 4b, an die verschieden hohe Gleichspannungen, nämlich ±1 V und ±8 V angelegt sind. Der Eingang des Tiefpasses 5 ist mit dem Wahlschalter 7 in Abhängigkeit von der Frequenzabweichung im Signal 1 zwischen den beiden Ausgängen der Umschalter 4a und 4b umschaltbar. Diese Umschaltung erfolgt mit einer Stellgröße Us, die in dem Prozessor 2 in Abhängigkeit von der tatsächlichen Frequenzabweichung im Signal 1 ermittelt wird und eine Umschaltung zwischen einem Fein-Regelbereich und einem Grob-Regelbereich bewirkt. Diese beiden Bereiche werden im folgenden beschrieben.

### Fein-Regelbereich

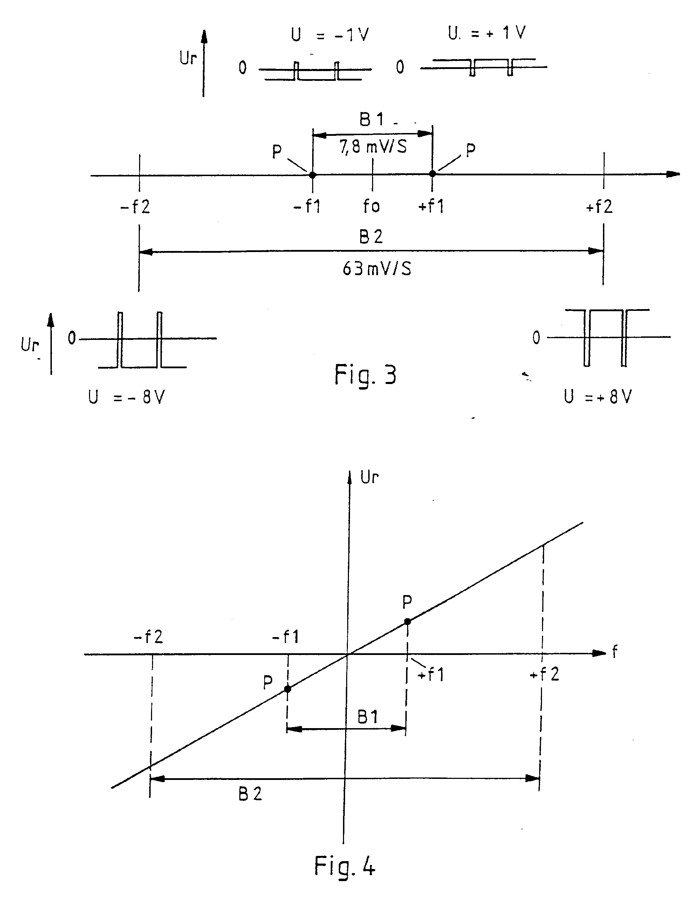

In Fig. 3 ist der Fein-Regelbereich durch die Abweichungen von -f1 und +f1 von der Sollfrequenz fo des Signals 1 dargestellt. Für diesen Regelbereich ist der Wahlschalter 7 auf den Ausgang des Umschalters 4a geschaltet, so daß maximal eine Regelspannung Ur von ±1 V gewonnen werden kann. Der Prozessor 2 arbeitet innerhalb dieses Regelbereiches so, daß eine Frequenzabweichung von -f1 oder +f1 gerade eine Impulsweitenmodulation von 100% im Signal 3 bewirkt. Die gesamte Stufenzahl von 256, die der Prozessor 2 für das modulierte Signal 3 verfügbar hat, wird also auf den Fein-Regelbereich B1 aufgeteilt, so daß sich pro Stufe S eine Änderung der Regelspannung Ur von 2000 mV:256=7,8 mV ergibt. Dieser Wert ist ausreichend gering für die angestrebte feine Frequenzregelung des Motors M im stationären synchronen Bereich B1.

### Grob-Regelbereich

Wenn die Frequenzabweichung in der Spannung 1 die Werte von -f1 oder +f1 überschreitet, würde die Regelschaltung nicht mehr funktionieren, weil die Regelschaltung mit dem Umschalter 4a eine größere Regelspannung als +1 V oder -1 V nicht liefern kann. Deshalb wird im Übergangspunkt P des Regelbereiches B1 in dem Regelbereich B2 der Wahlschalter 7 durch die Stellgröße Us auf den Ausgang des Umschalters 4b umgeschaltet. Durch die erhöhte Gleichspannung von 8 V an den Eingängen des Umschalters 4b kann jetzt die Regelspannung Ur Werte zwischen -8 V und +8 V annehmen. Wenn jedoch die Modulation des Signals 3 im Übergangspunkt P unverändert 100% bleibt, würde die Regelspannung in diesem Punkt um diesen Faktor springen. Deshalb wird synchron mit der Betätigung des Wahlschalters 7 der Modulationsgrad der PWM des Signals 3 im Übergangspunkt P auf einen geringeren Wert umgeschaltet, und zwar derart, daß trotz der von 1 V auf 8 V erhöhten Gleichspannung die erzeugte Regelspannung Ur zunächst konstant bleibt. Die Umschaltung erfolgt z.B. zwischen einem Modulationsgrad von 99% auf einen Modulationsgrad von z.B. 56%. Die Schaltung arbeitet jetzt mit dem erhöhten Regelbereich B2 zwischen -f2 und +f2 im Sinne der angestrebten Grobregelung. Die Stufenzahl der PWM beträgt weiterhin 256, so daß jetzt diese Stufenzahl auf den Bereich der Regelspannung von -8 V und +8 V aufgeteilt ist. Dadurch ergibt sich eine geringere Auflösung von 16000 mV:256=62,5 mV pro Stufe S der PWM-Modulation des Signals 3. Die Auflösung ist also gegenüber dem Bereich B1 in erwünschter Weise entsprechend verringert. Diese Grobregelung würde gemäß Fig. 4 an sich auch im Bereich B1 mit entsprechend geringer Auflösung wirken. Sie ist aber in diesem Bereich durch den Wahlschalter 7 durch Einschaltung der Feinregelung mit dem Umschalter 4a ausgeschaltet.

Je nach Größe der Frequenzabweichung im Signal 1 sind also wahlweise der Fein-Regelbereich B1 zwischen -f1 und +f1 mit einem Regelspannungsbereich von Ur von -1 V bis +1 V mit hoher Auflösung und ein Grob-Regelbereich B2 zwischen einer Frequenzabweichung von -f2 bis +f2 mit einer geringen Auflösung wirksam. Anstelle der zwei Umschalter 4a und 4b mit angelegten Gleichspannungen unterschiedlicher Größe könnte auch ein einziger durch das Signal 3 betätigter Umschalter vorgesehen sein, an dessen Eingänge wahlweise Gleichspannungen unterschiedlicher Größe angelegt werden. Die Eingänge des einzigen Umschalters können von einem elektronisch stabilisierten Netzgerät geliefert sein, dessen Ausgangsspannung elektronisch durch Einwirkung auf den Regelkreis zwischen 1 V und 8 V durch die Stellgröße Us umgeschaltet wird. Der Wahlschalter 7 würde dann entfallen, während die Stellgröße Us auf das den einzigen Umschalter 4 steuernde Netzgerät zur Umschaltung zwischen den Bereichen B1 und B2 einwirkt. Es können auch mehr als zwei Umschalter 4 vorgesehen sein, an die zur Unterscheidung in mehr als zwei Regelbereiche entsprechend Gleichspannungen verschiedener Größe angelegt sind. Die jeweils an die Eingänge eines Umschalters angelegten Gleichspannungen müssen nicht unbedingt gleich groß positiv und negativ sein. Sie können auch unterschiedliche Amplitude der selben Polarität haben. Die Regelspannung Ur hätte dann einen Gleichspannungsmittelwert für den bisher beschriebenen Fall Ur = O, wenn das Signal 1 die Sollfrequenz fo von 22 kHz hat. Dadurch ist es insbesondere möglich, sich an unterschiedliche Motoren mit unterschiedlichen Arbeitspunkten bei der Solldrehzahl anzupassen. Das es sich um eine Mikroprozessorregelung handelt, kann diese Anpassung in einem kurzen Testlauf (ca. ls lang) bei jedem Einschalten des Gerätes erfolgen, wodurch z.B. die Alterung des Motors und die Veränderung der Motordaten ausgeglichen werden können.

## Patentansprüche

1. Regelschaltung, bei der ein aus einer Frequenzabweichung gewonnenes impulsweitenmoduliertes Signal (3) den Ausgang eines Umschalters (4) zwischen zwei verschieden hohen Gleichspannungen (+U, -U) umschaltet und der Ausgang mit dem Eingang eines eine analoge Regelspannung (Ur) lieferndes Tiefpasses (5) verbunden ist, dadurch gekennzeichnet, daß zur Bildung eines Fein-Regelbereiches (B1) und eines Grob-Regelbereiches (B2) bei gleicher Stufenzahl der Impulsweitenmodulation der Eingang des Tiefpasses (5) über einen in Abhängigkeit von der Abweichung (f1, f2) betätigten Wahlschalter (7) an den Ausgang eines zweiten, von demselben impulsweitenmodulierten Signal (3) gesteuerten Umschalters (4b) umschaltbar ist, an den Gleichspannungen einer anderen Größenordnung (±8 V) als beim ersten Umschalter (4a) angelegt sind, und daß im Übergangspunkt (P) von dem Fein-Regelbereich (B1) zu dem Grob-Regelbereich (B2) der Modulationsgrad der Impulsweitenmodulation entsprechend der Erhöhung der an den jeweils wirksamen Umschalter (4a, 4b) angelegten Gleichspannungen (1 V bzw. 8 V) so verringert wird, daß sich ein kontinuierlicher Verlauf der erzeugten analogen Regelspannung (Ur) über beide Regelbereiche (B1, B2) ergibt.

2. Schaltung nach Anspruch 1, dadurch gekennzeichnet, daß die beiden jeweils an die Eingänge eines Umschalters (4a, 4b) angelegten Gleichspannungen (±1 V; ±8 V) gleichen Betrag und entgegengesetztes Vorzeichen haben.

3. Schaltung nach Anspruch 1, dadurch gekennzeichnet, daß ein erster Umschalter (4a) mit kleinen angelegten Gleichspannungen (±1 V) für einen Fein-Regelbereich (B1) für geringe Frequenzabweichungen (±f1) mit 100% Pulsweitenmodulation und ein zweiter Umschalter (4b) mit größeren angelegten Gleichspannungen (±8 V) für einen Grob-Regelbereich (B2) mit großen Frequenzabweichungen (±f2) und ebenfalls 100% Pulsweitenmodulation vorgesehen ist.

4. Schaltung nach Anspruch 1, dadurch gekennzeichnet, daß die beiden Umschalter (4a, 4b) und der Wahlschalter (7) durch einen Umschalter ersetzt sind, an dessen Eingänge wahlweise verschieden hohe Gleichspannungen (1 V, 8 V) angelegt werden.

5. Schaltung nach Anspruch 1, dadurch gekennzeichnet, daß die Lage des durch einen Umschalter (4a) gebildeten Feinregelbereiches (B1) an beliebiger Stelle innerhalb des durch den anderen Umschalter (4b) gebildeten Grobregelbereiches (B2) liegt.

6. Schaltung nach Anspruch 5, dadurch gekennzeichnet, daß die Breite des Feinregelbereiches (B1) und damit die Auflösung klein sind gegenüber dem Grobregelbereich (B2).

## Claims

1. Control circuit in which a pulse-width modulated signal (3) obtained from a frequency deviation changes over the output of a change-over switch (4) between two d.c. voltages (+U, -U) of a different level, and the output is connected to the input of a low-pass filter (5) which supplies an analogue control voltage (Ur), characterised in that, in order to form a fine control range (B1) and a coarse control range (B2) with the same number of steps of the pulse-width modulation, the input of the low-pass filter (5) can be changed over by a selector switch (7), which is operated according to the deviation (f1, f2), to the output of a second change-over switch (4b), which is controlled by the same pulse-width modulated signal (3) and to which d.c. voltages are applied which are of a magnitude (±8 V) which is different to that of the voltages applied to the first change-over switch (4a), and that the modulation factor of the pulse-width modulation is reduced at the transition point (P) from the fine control range (BI) to the coarse control range (B2) according to the increase in the d.c. voltages (1 V and 8 V) applied to the respective effective change-over switch (4a, 4b) so as to produce a continuous curve of the analogue control voltage (Ur) which is generated over both control ranges (B1, B2).

2. Circuit according to claim 1, characterised in that the two d.c. voltages (±1 V; ±8 V) which are in each case applied to the inputs of a change-over switch (4a, 4b) have the same value and opposite signs.

3. Circuit according to claim 1, characterised in that a first change-over switch (4a) with low applied d.c. voltages (±1 V) is provided for a fine control range (B1) for small frequency deviations (±f1) with 100% pulse-width modulation and a second change-over switch (4b) with higher applied d.c. voltages (±8 V) is provided for a coarse control range (B2) with large frequency deviations (±f2) and 100% pulse-width modulation.

4. Circuit according to claim 1, characterised in that the two change-over switches (4a, 4b) and the selector switch (7) are replaced by one change-over switch, to the inputs of which d.c. voltages (1 V, 8 V) of a different level are selectively applied.

5. Circuit according to claim 1, characterised in that the position of the fine control range (B1) formed by one change-over switch (4a) lies at any desired point within the coarse control range (B2) formed by the other change-over switch (4b).

6. Circuit according to claim 5, characterised in that the fine control range (B1) is narrow and thus the resolution fine with respect to the coarse control range (B2).

## Revendications

1. Circuit de réglage dans lequel un signal à impulsions modulées en largeur (3) obtenu à partir d'un écart de fréquence, commute la sortie d'un commutateur (4) entre deux tensions continues de différente grandeur (+U, -U) et la sortie est reliée à l'entrée d'un passe-bas (5) qui fournit une tension de réglage analogique (Ur), **caractérisé en ce** que, pour former une plage de réglage fin (B1) et une plage de réglage grossier (B2), pour un même nombre d'étages de la modulation d'impulsions en largeur l'entrée du passe-bas (5) peut être commutée, par l'intermédiaire d'un sélecteur (7) actionné en fonction de l'écart (f1, f2), à la sortie d'un second commutateur (4b) commandé par le même signal (3) à impulsions modulées en largeur, auquel des tensions continues d'un autre ordre de grandeur (±8V) que pour le premier commutateur (4a) sont appliquées et qu'au point de transition (P) de la plage de réglage fin (B1) à la plage de réglage grossier (B2) le taux de modulation de la modulation d'impulsions en largeur est diminué selon l'augmentation des tensions continues (1V ou 8V) appliquées au commutateur respectivement efficace (4a, 4b) de telle manière qu'on obtient une courbe continue de la tension de réglage analogique produite (Ur) sur les deux plages de réglage (B1, B2).

2. Circuit selon la revendication 1, **caractérisé en ce** que les deux tensions continues (±1V: ±8V) appliquées respectivement aux entrées d'un commutateur (4a, 4b) présentent la même valeur et le signe opposé.

3. Circuit selon la revendication 1, **caractérisé en ce** qu'un premier commutateur (4a) est prévu avec de petites tensions continues (±1V) pour une plage de réglage fin (B1) pour des faibles écarts de fréquence (±f1) avec une modulation d'impulsions en largeur de 100% et qu'un second commutateur (4b) est prévu avec des tensions continues appliquées plus importantes (±8V) pour une plage de réglage grossier (B2) avec des grands écarts de fréquence (±f2) et également une modulation d'impulsions en largeur de 100%.

4. Circuit selon la revendication 1, **caractérisé en ce** que les deux commutateurs (4a, 4b) et le sélecteur (7) peuvent être remplacés par un commutateur aux entrées duquel des tensions continues de différente hauteur sont appliquées au choix (1V, 8V).

5. Circuit selon la revendication 1, **caractérisé en ce** que la position de la plage de réglage fin (B1) formée par un commutateur (4a) se situe à nimporte quel endroit à l'intérieur de la plage de réglage grossier (B2) formée par l'autre commutateur (4b).

6. Circuit selon la revendication 5, **caractérisé en ce** que la largeur de la plage de réglage fin (B1) et donc la résolution sont petites par rapport à la plage de réglage grossier (B2).
